# DEMANDE DE BREVET EUROPEEN

(11) **EP 1 249 843 A2**
(43) Date de publication de la demande: **16.10.2002**
(21) Numéro de dépôt: 02290353.8
(22) Date de dépôt: 13.02.2002
(51) Int. Cl.: G11C 29/00

(54) **Procédé de test d'un plan-mémoire à accès séquentiel, et dispositif semiconducteur de mémoire à accès séquentiel correspondant**

(30) Priorité: 21.02.2001 FR 0102333
(71) Demandeur: STMicroelectronics S.A., 92120 Montrouge (FR)
(72) Inventeur: Beaujoin, Marc, 38000 Grenoble (FR); Alofs, Thomas, 38100 Grenoble (FR); Armagnat, Paul, 38170 Seyssinet (FR)
(74) Mandataire: Casalonga, Axel

(57) **Abrégé**

Le plan-mémoire à accès séquentiel est capable de stocker p mots de n bits. On écrit dans le plan-mémoire p mots de test composé chacun de n bits de test (DT), on extrait séquentiellement les p mots de test, et pour chaque mot courant extrait on compare séquentiellement respectivement les n bits de test qui le composent avec n données attendues (DAi), avant d'extraire le mot de test suivant.

## Description

L'invention concerne les mémoires à accès séquentiel, en particulier les mémoires du type "premier entré-premier sorti" (FIFO en langue anglaise), et notamment le test de ces mémoires, qui utilise un circuit spécifique de test intégré lors de la fabrication de la mémoire et l'algorithme de test associé (connu par l'homme du métier sous la dénomination anglaise "BIST" : Built In Self Test).

Actuellement, un circuit de test intégré à une mémoire et l'algorithme de test associé permettent, sur commande, d'écrire dans le plan-mémoire des mots spécifiques de test, puis de les extraire et de comparer les bits de test de ces mots extraits avec des données binaires attendues.

Or, ceci nécessite l'utilisation d'une logique de décodage connectée en sortie du plan-mémoire, recevant par ailleurs les données attendues, et dont l'encombrement est d'autant plus important que la largeur du bus de données de la mémoire, c'est-à-dire le nombre de bits des mots de test, est importante.

Par ailleurs, outre cet aspect pénalisant de l'encombrement de surface, une telle logique de décodage pose des problèmes importants de réalisation matérielle ("routabilité") des différentes connexions entre les différents éléments de la logique de décodage.

L'invention vise à apporter une solution à ce problème.

L'invention a pour but de proposer un test d'un plan-mémoire à accès séquentiel, totalement différent de ceux pratiqués jusqu'alors, et qui permette une réalisation particulièrement simple conduisant à un encombrement extrêmement réduit de la logique de test.

L'invention propose donc un procédé de test d'un plan-mémoire à accès séquentiel capable de stocker p mots de n bits. Dans ce procédé, on écrit dans le plan-mémoire p mots de test composés chacun de n bits de test. On extrait les p mots de test du plan-mémoire et on compare les bits de test de ces mots extraits avec des données binaires attendues.

Selon une caractéristique générale de l'invention, on extrait séquentiellement les p mots de test et, pour chaque mot courant extrait, on compare séquentiellement respectivement les n bits de test qui le composent avec n données attendues, avant d'extraire le mot de test suivant.

En d'autres termes, contrairement aux tests classiques de l'art antérieur dans lesquels on comparait simultanément en parallèle les n bits d'un mot de test extrait avec un mot de données attendu, on effectue, selon l'invention, cette comparaison bit par bit séquentiellement pour chaque mot extrait, ce qui permet d'utiliser une logique de comparaison extrêmement simple, comportant par exemple une portie logique OU EXCUSIF.

Selon un mode de mise en oeuvre du procédé, on écrit les p mots de test de n bits de façon à obtenir dans le plan-mémoire une configuration binaire de test en damier. Les données attendues sont alors séquentiellement obtenues à partir des combinaisons logiques respectives des adresses de lecture des mots de test avec les rangs des bits de test dans chaque mot lu.

Un tel mode de mise en oeuvre permet de générer de façon extrêmement simple les données attendues.

L'invention a également pour objet un dispositif semiconducteur de mémoire à accès séquentiel, comprenant un plan-mémoire capable de stocker p mots de n bits, et une logique de test connectée aux n sorties du plan-mémoire. Cette logique de test comprend des premiers moyens de test aptes à écrire dans le plan-mémoire p mots de test composés chacun de n bits de test ainsi que des deuxièmes moyens de test aptes à extraire les p mots de test du plan-mémoire et à comparer les bits de test de ces mots extraits avec des données binaires attendues.

Selon une caractéristique générale de l'invention, les deuxièmes moyens de test sont aptes à extraire séquentiellement les p mots de test, et, pour chaque mot courant extrait, à comparer séquentiellement respectivement les n bits de test qui le composent avec n données attendues, avant d'extraire le mot de test suivant.

Selon un mode de réalisation de l'invention, les deuxièmes moyens de test comportent :
- un ensemble de n registres de sorties respectivement connectés aux n sorties du plan-mémoire, tous ces registres étant en outre chaînés,
- des premiers moyens de commande aptes à délivrer aux n registres de sortie un premier signal de commande de façon à stocker simultanément dans ces n registres, les n bits de test du mot courant de test,
- des deuxièmes moyens de commande aptes à délivrer aux n registres de sortie, un deuxième signal de commande de façon à décaler séquentiellement le bit de test contenu dans un registre de la chaîne, vers le registre suivant, et extraire séquentiellement du registre situé en bout de chaîne, les n bits de test du mot de test courant, et
- des moyens de comparaison aptes à comparer chaque bit extrait dudit registre situé en bout de chaîne, avec la donnée attendue correspondante.

Chaque registre de sortie est par exemple une bascule D possédant une entrée de donnée reliée à l'une des n sorties du plan-mémoire, une entrée de test, une sortie de test, et une entrée de commande de test pour recevoir successivement et alternativement le premier signal de commande et le deuxième signal de commande. La sortie de test d'une bascule est alors reliée à l'entrée de test de la bascule adjacente de façon à former ladite chaîne. L'entrée de test de la première bascule de la chaîne est apte à recevoir une donnée initiale (par exemple présente en sortie d'une autre bascule ou bien d'un registre). Enfin, la sortie de test de la dernière bascule de la chaîne est reliée à une première entrée des moyens de comparaison.

Ces moyens de comparaison peuvent comporter par exemple une porte logique OU EXCLUSIF, éventuellement associée à un inverseur.

Généralement les registres de sortie d'une mémoire à accès séquentiel (FIFO par exemple) sont déjà chaînés et reliés en série avec d'autres chaînes d'autres blocs présents sur le circuit intégré, pour former une chaîne de test connue par l'homme du métier sous la dénomination anglaise de "scan chain". L'invention est ici remarquable en ce sens qu'elle utilise en partie cette chaîne pour effectuer le test selon l'invention ( BIST).

Selon un mode de réalisation de l'invention, les premiers moyens de test sont aptes à écrire les p mots de test de n bits de façon à obtenir dans le plan-mémoire une configuration binaire de test en damier. La logique de test comporte alors des moyens de génération aptes à générer séquentiellement les données attendues à partir des combinaisons logiques respectives des adresses de lecture des mots de test avec les rangs des bits de test dans chaque mot lu.

Les moyens de génération comportent avantageusement :
- des premiers moyens aptes à délivrer le bit de poids faible de chaque adresse de lecture,
- un compteur apte à contenir un mot binaire représentatif du rang d'un bit de test dans le mot courant extrait du plan-mémoire,
- des deuxièmes moyens aptes à délivrer le bit de poids faible de chaque mot binaire contenu dans le compteur, et
- une porte logique OU EXCLUSIF dont les deux entrées sont respectivement connectées aux deux sorties des premier et deuxième moyens, et dont la sortie délivre séquentiellement les données attendues.

D'autres avantages et caractéristiques de l'invention apparaîtront à l'examen de la description détaillée de modes de mise en oeuvre et de réalisation, nullement limitatifs, et des dessins annexés, sur lesquels :
- la figure 1 illustre schématiquement un mode de réalisation d'un dispositif de mémoire selon l'invention; et
- la figure 2 représente schématiquement un chronogramme temporel illustrant un mode de mise en oeuvre du procédé selon l'invention.

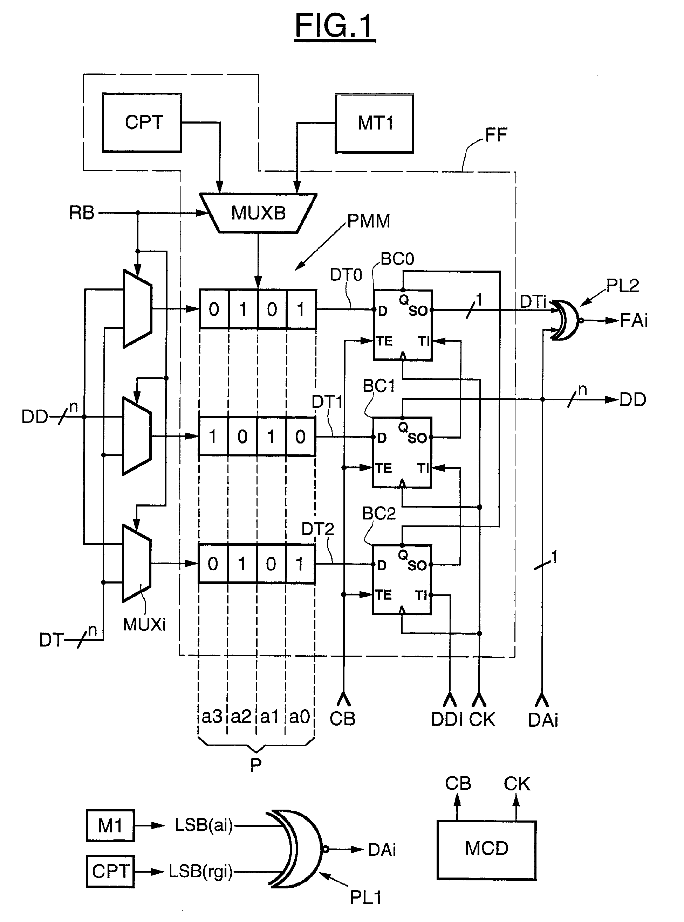

Sur la figure 1, la référence FF désigne un dispositif de mémoire à accès séquentiel, par exemple une mémoire du type FIFO.

Cette mémoire FF comporte un plan-mémoire PMM capable de stocker p mots de n bits. En d'autres termes, la profondeur de cette mémoire est égale à p et la largeur du bus de données est égale à n. Dans l'exemple décrit ici, à des fins de simplification, p est égal à 4 et n est égal à 3.

Sur cette figure, les références ai désignent les adresses de stockage successives des p mots dans le plan-mémoire PMM.

L'écriture et la lecture en mode normal de fonctionnement sont effectuées de façon classique par des pointeurs d'écriture et de lecture commandés, également de façon classique, par des moyens de commande CPT.

Un multiplexeur MUXB permet, en réponse à un signal de commande RB, de contrôler les pointeurs d'écriture et de lecture du plan-mémoire, soit à partir des moyens de commande CPT (en mode normal de fonctionnement), soit à partir de moyens de commande MT1 (pour un fonctionnement en mode de test).

De même, la sélection des données à écrire dans le plan-mémoire s'effectue par l'intermédiaire de n multiplexeurs MUXi, commandés également par le signal de commande RB.

Ainsi, en mode de fonctionnement normal, les n données DD présentes sur le bus sont écrites dans le plan-mémoire.

Par contre, en mode de test, ce sont des données binaires de test DT qui sont écrites dans le plan-mémoire PMM.

Les moyens de commande MT1 ainsi que les multiplexeurs MUXi et MUXB forment alors des premiers moyens de test aptes, en combinaison avec les données de test DT, à écrire dans le plan-mémoire p mots de test composés chacun de n bits de test. Par ailleurs, selon un mode de réalisation préférentiel, les premiers moyens de test écrivent les p mots de test de n bits de façon à obtenir dans le plan-mémoire une configuration de test en damier. Une configuration en damier, telle que celle illustrée sur la figure 1, est une configuration dans laquelle chaque mot de test comporte une alternance de 0 et 1, et dans laquelle les 0 et les 1 de deux mots écrits à deux adresses successives sont mutuellement décalés d'un bit.

La mémoire FF comporte par ailleurs n registres de sortie BC0-BC2. Ces registres de sortie sont ici des bascules D, possédant chacune une entrée de donnée D reliée à l'une des n sorties du plan-mémoire PMM. Chaque bascule D possède par ailleurs une entrée de test TI, une sortie de test SO et une entrée de commande de test TE. Par ailleurs, chaque bascule est commandée temporellement par un signal d'horloge CK.

Enfin, chaque bascule comporte une sortie de donnée Q.

En mode de fonctionnement normal, les n données extraites de la mémoire PMM sont délivrées aux n entrées de données respectives D des bascules, puis délivrées aux n sorties de données Q au rythme des fronts montants du signal d'horloge CK.

Par contre, il en est autrement en mode de test, comme cela va maintenant être expliqué plus en détail.

En effet, outre le fait que ces n bascules soient respectivement connectées aux n sorties du plan-mémoire PMM par l'intermédiaire de leur entrée de données D, elles sont chaînées. Plus précisément, la sortie de test SO d'une bascule, BC 1 par exemple, est reliée à l'entrée de test TI de la bascule adjacente, BC0 par exemple, de façon à former une chaîne. Par ailleurs, l'entrée de test TI de la première bascule BC2 de la chaîne est reliée à un moyen de stockage contenant une donnée initiale DDI. En fait, la valeur de cette donnée initiale n'a aucune importance, comme on le verra plus en détail ci-après. Le moyen de stockage peut être par exemple la sortie d'une autre bascule d'un autre élément du circuit intégré. L'entrée TI de la première bascule BC2 peut être également reliée à la masse par câblage.

Toutes les entrées de commande de test TE reçoivent un signal CB émanant de moyens de commande MCD. Lorsque le signal CB prend par exemple la valeur 0, il constitue alors un premier signal de commande, et une donnée présente à l'entrée D d'une bascule est alors délivrée à la sortie SO au front montant suivant de l'horloge CK.

Par contre, lorsque le signal CB prend la valeur 1, il constitue alors un deuxième signal de commande et, dans ce cas, chaque bascule délivre à la sortie SO la donnée présente à l'entrée de test TI, au rythme des fronts montants du signal d'horloge CK.

La structure et le fonctionnement d'une telle bascule D, équipée en outre d'une entrée de test, d'une sortie de test et d'une entrée de commande de test, sont parfaitement connus de l'homme du métier.

Par ailleurs, il est prévu des moyens de comparaison formés ici d'une porte logique NON OU EXCLUSIF PL2. Une première entrée de cette porte logique PL2 est reliée à la sortie de test SO de la bascule BC0 située en bout de chaîne. L'autre entrée de la porte logique PL2 reçoit séquentiellement les données attendues DAi.

La sortie de cette porte logique PL2 est un signal logique qui prend la valeur 0 ou 1, au rythme des comparaisons, en fonction du résultat de ces comparaisons.

Lorsqu'on utilise une configuration de test en damier, un moyen très simple de générer les données attendues DAi est illustré sur la partie basse de la figure 1.

Plus précisément, ce moyen consiste à effectuer une combinaison logique du bit de poids faible LSB de l'adresse de lecture ai du mot de test lu, et du bit de poids faible LSB du rang ngi du bit de test lu dans le mot considéré.

Plus précisément, si par exemple, comme illustré sur la figure 1, l'adresse de lecture a0 est l'adresse 00 en binaire, que l'adresse de lecture a1 est l'adresse 01, que l'adresse de lecture a2 est l'adresse 10 et que l'adresse de lecture a3 est l'adresse 11, les premiers moyens M1 qui vont délivrer le bit de poids faible de chaque adresse de lecture vont délivrer en ce qui concerne le mot de test situé à l'adresse a0, la valeur 0.

Par ailleurs, un compteur CT, incrémenté au rythme du signal d'horloge CK, va compter de 0 à n-1. Si l'on suppose que la valeur 0 est représentative du rang du bit de test DT0, le bit de poids faible de la valeur du compteur est égal à 0 pour le bit de test DT0, à 1 pour le bit de test DT1 et à 0 pour le bit de test DT2.

La combinaison logique du bit de poids faible de l'adresse de lecture LSB (ai) et du bit de poids faible LSB (rgi) de la valeur du compteur, dans la porte logique NON OU EXCLUSIF, référencée PL1, fournit bien séquentiellement les valeurs 1, 0 et 1 correspondant au mot de test stocké à l'adresse a0 dans le plan-mémoire PMM.

Bien entendu, dans le cas où le mot de test stocké à l'adresse a0 aurait été 0 1 0, la porte logique PL1 aurait été simplement une porte logique OU EXCLUSIF.

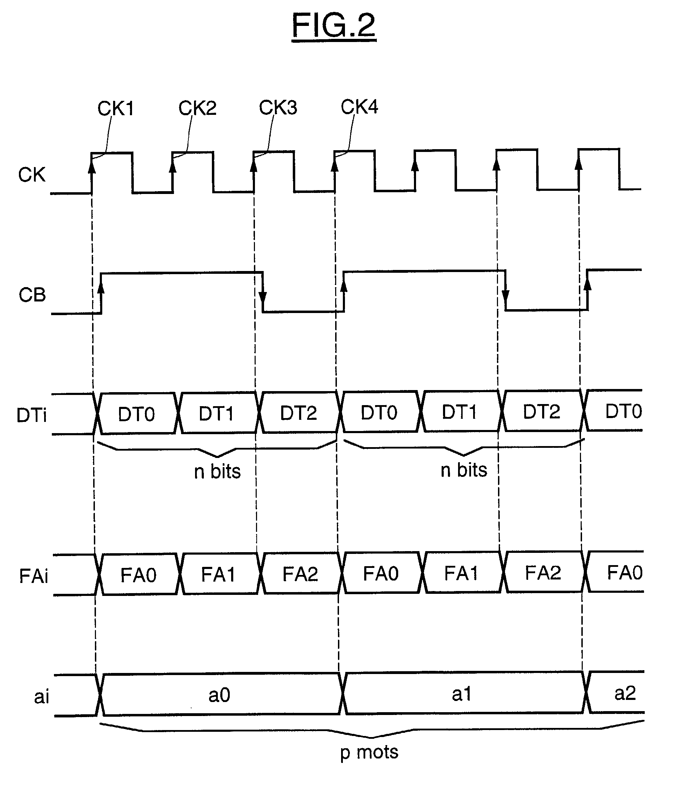

On va maintenant décrire plus en détail le test du plan-mémoire PMM en se référant plus particulièrement à la figure 2.

Les moyens de commande MCD, qui délivrent le signal d'horloge CK, confèrent tout d'abord la valeur 0 au signal CB (premier signal de commande). En conséquence, à l'apparition du premier front montant d'horloge CK1, les données de test DT0, DT1 et DT2 du mot de test stocké à l'adresse a0, sont simultanément délivrées aux sorties respectives de test SO des bascules BC0, BC1 et BC2. Dans le même cycle, la donnée DT0, disponible à la sortie de test SO de la bascule BC0, est comparée dans la porte logique PL2 à la donnée attendue DA0. Le résultat de la comparaison est fourni par la valeur FA0 du signal FAi.

Par ailleurs, dans le même cycle du signal d'horloge, la donnée DT2 est disponible à l'entrée de test TI de la bascule BC1 et la donnée de test DT1 est disponible à l'entrée de test TI de la bascule BC0.

Après le front montant CK1 du signal d'horloge, et avant le front montant suivant CK2, les moyens de commande MCD font passer à 1 le signal CB (deuxième signal de commande).

De ce fait, au front montant suivant CK2 du signal d'horloge CK, il se produit un décalage des données disponibles en sortie de test SO des bascules, vers la bascule située en bout de chaîne.

Plus précisément, la donnée initiale DDI est alors disponible à la sortie SO de la bascule BC2. La donnée de test DT2 est disponible à la sortie de test SO de la bascule BC 1 et la donnée de test DT1 est disponible à la sortie de test SO de la bascule BC0. Cette dernière donnée peut alors être testée par comparaison dans la porte logique PL2 avec la donnée attendue correspondante DA1.

Au front montant d'horloge suivant CK3, le signal CB est toujours à 1. De ce fait, c'est maintenant la donnée DT2 qui est disponible à la sortie de test SO de la bascule BC0 et qui peut être comparée à la donnée attendue DA2 dans la porte logique PL2.

A cet instant là, l'ensemble du mot de test qui était stocké dans le plan-mémoire PMM à l'adresse de lecture a0 a été testé.

Pour tester le mot de test suivant, qui avait été stocké à l'adresse de lecture a1 qui est maintenant disponible en sortie du plan-mémoire PMM, les moyens de commande MCD refont passer le signal CB à 0, ce qui a pour conséquence, au front montant suivant CK4 du signal d'horloge, de délivrer en sortie de test SO des bascules BC2, BC1 et BC0 les bits de test DT2, DT1 et DT0 de ce mot de test suivant.

Puis, après ce front montant d'horloge CK4, le signal CB est à nouveau mis à la valeur logique 1, et le processus de décalage et de test séquentiel des bits de test du mot de test s'effectue d'une façon analogue à celle qui vient d'être décrite pour le mot de test précédent.

Il convient donc de noter ici que la donnée initiale DDI n'intervient jamais dans le test et par conséquent sa valeur est sans importance.

L'invention a donc permis un test très simple du plan-mémoire, à la fréquence normale de fonctionnement du circuit, et en utilisant une logique de test extrêmement simple et réduite.

L'invention n'est pas limitée aux modes de réalisation et de mise en oeuvre qui viennent d'être décrits, mais en embrasse toutes les variantes. Ainsi, le test selon l'invention pourrait s'appliquer aisément à une mémoire à accès séquentiel du type dernier entré-premier sorti (LIFO en langue anglaise).

## Revendications

1. Procédé de test d'un plan-mémoire à accès séquentiel capable de stocker p mots de n bits, procédé dans lequel on écrit dans le plan-mémoire p mots de test composé chacun de n bits de test (DT), on extrait les p mots de test du plan-mémoire et on compare les bits de test de ces mots extraits avec des données binaires attendues (DAi), **caractérisé par le fait qu'**on extrait séquentiellement les p mots de test, et pour chaque mot courant extrait on compare séquentiellement respectivement les n bits de test qui le composent avec n données attendues (DAi), avant d'extraire le mot de test suivant.

2. Procédé selon la revendication 1, **caractérisé par le fait qu'**on écrit les p mots de test de n bits de façon à obtenir dans le plan-mémoire une configuration binaire de test en damier, et **par le fait que** les données attendues sont séquentiellement obtenues à partir des combinaisons logiques respectives des adresses de lecture (ai) des mots de test avec les rangs (rgi) des bits de test dans chaque mot lu.

3. Dispositif semiconducteur de mémoire à accès séquentiel, comprenant un plan-mémoire (PMM) capable de stocker p mots de n bits, et une logique de test, connectée aux n sorties du plan-mémoire, et comprenant des premiers moyens de test (MT1) aptes à écrire dans le plan-mémoire p mots de test composé chacun de n bits de test ainsi que des deuxièmes moyens de test aptes à extraire les p mots de test du plan-mémoire et à comparer les bits de test de ces mots extraits avec des données binaires attendues, **caractérisé par le fait que** les deuxièmes moyens de test sont aptes à extraire séquentiellement les p mots de test, et pour chaque mot courant extrait, à comparer séquentiellement respectivement les n bits de test qui le composent avec n données attendues, avant d'extraire le mot de test suivant.

4. Dispositif selon la revendication 3, **caractérisé par le fait que** les deuxièmes moyens de test comportent :
- un ensemble de n registres de sorties (BCi) respectivement connectés aux n sorties du plan-mémoire, tous ces registres étant en outre chaînés,
- des premiers moyens de commande (MCD) aptes à délivrer aux n registres de sortie un premier signal de commande (CB) de façon à stocker simultanément dans ces n registres, les n bits de test du mot courant de test,
- des deuxièmes moyens de commande (MCD) aptes à délivrer aux n registres de sortie, un deuxième signal de commande (CB) de façon à décaler séquentiellement le bit de test contenu dans un registre de la chaîne, vers le registre suivant, et extraire séquentiellement du registre situé en bout de chaîne, les n bits de test du mot de test courant, et
- des moyens de comparaison (PL2) aptes à comparer chaque bit extrait dudit registre situé en bout de chaîne, avec la donnée attendue correspondante.

5. Dispositif selon la revendication 4, **caractérisé par le fait que** chaque registre de sortie (BCi) est une bascule D possédant une entrée de donnée (D) reliée à l'une des n sorties du plan mémoire, une entrée de test (TI), une sortie de test (SO), et une entrée de commande de test (TE) pour recevoir successivement et alternativement le premier signal de commande et le deuxième signal de commmande (CB), **par le fait que** la sortie de test d'une bascule est reliée à l'entrée de test de la bascule adjacente de façon à former ladite chaîne, **par le fait que** l'entrée de test de la première bascule de la chaîne est apte à recevoir une donnée initiale (DDI), **par le fait que** la sortie de test de la dernière bascule est reliée à une première entrée des moyens de comparaison.

6. Dispositif selon la revendication 5, **caractérisé par le fait que** les moyens de comparaison (PL2) comportent une porte logique OU EXCLUSIF.

7. Dispositif selon l'une des revendications 3 à 6, **caractérisé par le fait que** les premiers moyens de test sont aptes à écrire les p mots de test de n bits de façon à obtenir dans le plan-mémoire une configuration binaire de test en damier, et **par le fait que** la logique de test comporte des moyens de génération (M1, CT) aptes à générer séquentiellement les données attendues à partir des combinaisons logiques respectives des adresses de lecture des mots de test avec les rangs des bits de test dans chaque mot lu.

8. Dispositif selon la revendication 7, **caractérisé par le fait que** les moyens de génération comportent :
- des premiers moyens (M1) aptes à délivrer le bit de poids faible de chaque adresse de lecture,
- un compteur (CT) apte à contenir un mot binaire représentatif du rang d'un bit de test dans le mot courant extrait du plan-mémoire,
- des deuxièmes moyens aptes à délivrer le bit de poids faible de chaque mot binaire contenu dans le compteur, et
- une porte logique OU EXCLUSIF (PL1) dont les deux entrées sont respectivement connectées aux deux sorties desdits premier et deuxième moyens, et dont la sortie délivre séquentiellement lesdites données attendues.
